# EUROPEAN PATENT SPECIFICATION

(11) **EP 1 845 766 B1**
(45) Date of publication and mention of the grant of the patent: **17.06.2009**
(21) Application number: 06007535.5
(22) Date of filing: 10.04.2006
(51) Int. Cl.: H05K 9/00, H05K 1/02, H05K 3/40

(54) **Hold down device**
Niederhaltevorrichtung
Dispositif de retenue

(43) Date of publication of application: 17.10.2007
(73) Proprietor: Harman Becker Automotive Systems GmbH, 76307 Karlsbad (DE)
(72) Inventor: Seitz, Christian, 71272 Renningen (DE); Rieger, Robby, 76307 Karlsbad-Ittersbach (DE)
(74) Representative: Bertsch, Florian Oliver

(56) References cited:
- EP-A- 0 892 593
- US-A- 5 792 994
- PATENT ABSTRACTS OF JAPAN vol. 2003, no. 11, 5 November 2003 (2003-11-05) & JP 2003 204185 A (MITSUMI ELECTRIC CO LTD), 18 July 2003 (2003-07-18)

## Description

This invention relates to a hold down device for fixing a cover on a circuit board and to a system comprising a circuit board, a cover and a hold down device. The invention finds especially application in system where the cover functions as a shielding cover for shielding electronic components that are positioned below the cover.

Especially in vehicles the use of different electronic components is a widespread phenomena. By way of example, vehicles often comprise multimedia systems, the multimedia systems comprising an audio module for playing music from a recording medium, a radio receiver module, a navigation module for guiding the driver of the vehicle to a predetermined destination and/or a telecommunication module for using a cellular phone inside the vehicle. All these different components have to be incorporated into a limited space behind the dashboard of the vehicle. For a proper functioning of the different modules, the electronic components of the modules have to be shielded against electromagnetic waves irradiated from other components. To this end, shielding covers are provided on the circuit board on which the electronic module is provided. This shielding cover avoids the irradiation of electromagnet waves to the outside of the cover, the cover also helps to prevent the penetration of electronic waves into the space covered by the shielding.

Electromagnetic shielding covers have to be fixed on the circuit boards on which the electronic components to be covered are provided. For fixing the covers on circuit boards, hold down devices are used which electrically contact the cover and which mechanically fix the cover on the circuit board. It should be understood that this invention is not restricted to vehicle applications. This invention finds application in all environments where a shielding cover has to be connected to a surface such as a circuit board. The hold down devices for fixing the cover to the circuit boards have to meet certain requirements. The hold down devices need to fix the cover to the circuit board in a reliable manner. At the same time high contact forces for electrically and mechanically contacting the hold down device to the cover are needed.

EP-A-0 892 593 A2 discloses a device for fixing a shielding cover to an electric circuit board comprising a clamping profile having a spigot for fixing the device to the circuit board.

US-A-5 792 994 discloses a device for mounting a component on a printed circuit board, the device comprising at least one leg and at least a resilient wall rising from a base.

Accordingly, a need exists to provide a hold down device which reliably assures the fixing of a cover to the hold down device and to a circuit board and which assures a good mechanical and electrical connection between the hold down device and the cover.

This need is met by the hold down device and the system as mentioned in the independent claims. The dependent claims relate to preferred embodiments of the invention.

According to a first aspect of the invention, the latter relates to a hold down device for fixing a cover on a circuit board, the hold down device comprising a base plate and two contact portions extending substantially perpendicular to the base plate. The two contact portions receive the cover in between, and each contact portion comprises two free ends, the free ends of each contact portion being bent in the direction of the other contact portion. The two contact portions, each of them having two free ends which are bent relative to the other contact portion, allow the provision of a hold down device having a high contact force. The contact force and the reliability of the electrical and mechanical contact of the hold down device to the cover can be controlled by the amount of the portion of the free end, which is bent in the direction of the other contact portion.

According to the invention, the two contact portions are facing each other and each contact portion has a U-shaped form. By providing contact portions having a U-shaped form facing each other, the contact forces can be adjusted by adjusting the distance of the two contact portions relative to each other and/or by adjusting the U-shape form.

Additionally, each contact portion may further comprise a connecting portion which is situated between the two free ends and which connects the two free ends together and which connects the free ends to the base plate. According to the invention, the end surfaces of the free ends are contacting the cover when the latter is inserted between the two contact portions.

According to a preferred embodiment, the end surfaces of the free ends of the two contact portions are positioned substantially within a plane which is perpendicular to the base plate. This means that, when the cover is not inserted between the two contact portions, the free ends abut against the same plane. In this case, the free ends are bent in such a way that the free ends are arranged offset relative to each other, the ends of the free ends being positioned in the same plane. When the end surfaces are arranged within one plane when the cover is not inserted, the distance between the contact surfaces is approximately zero. As a result, high contact forces and a reliable contact can be obtained between the two contact portions and the cover when it is inserted between the two contact portions. When the cover is inserted between the two contact portions, the distance of the free ends of one contact portion to the free ends of the other contact portion is increased from zero at the distance corresponding at least to the width of the cover.

It is also possible that the free ends of one contact portion are arranged overlapping the free ends of the other contact portion. With this overlapping arrangement of the free ends the contact force can be further increased, as the spring travel of the resilient free ends is further increased.

Additionally, the lower edge of the free ends of each contact portion can have a predetermined distance to the base plate. This lower edge of the contact portion can engage a projecting rib provided on the cover, so that once the cover is completely inserted into the hold down device, the hold down device keeps the cover in its position. Additionally, the upper edge of the contact portion may have a sloping form at the end of the free ends in order to facilitate the insertion of the circuit board into the hold down device.

The invention further relates to a system comprising a circuit board, a cover to be positioned on the circuit board and a hold down device which is connected to the circuit board and which is designed as described above. The cover comprises at least one projection rib on an outer or an inner surface. The lower edge of the free ends of the contact portions engage the projection rib in order to fix the cover on the circuit board.

The hold down device of this invention is further described with reference to the accompanying drawings, in which
Figure 1 is a perspective view of a hold down device of the invention,
Figures 2 and 3 are respective side views of the hold down device of Figure 1,
Figure 4 is a top view of the hold down device of Figure 1, and
Figure 5 is a perspective view of a shielding cover fixed to a base plate using the hold down device shown in Figures 1-4.

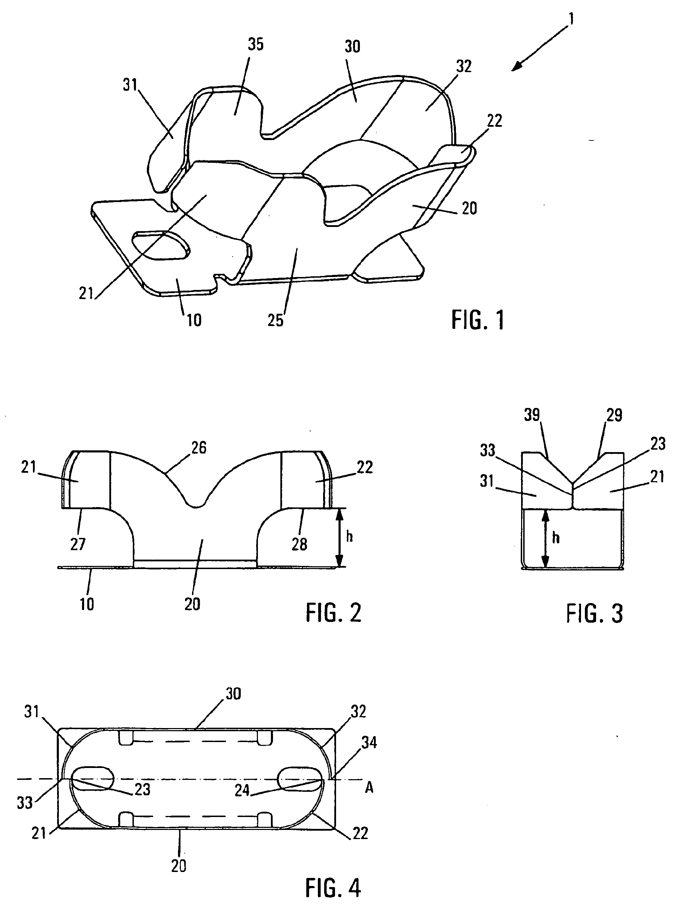

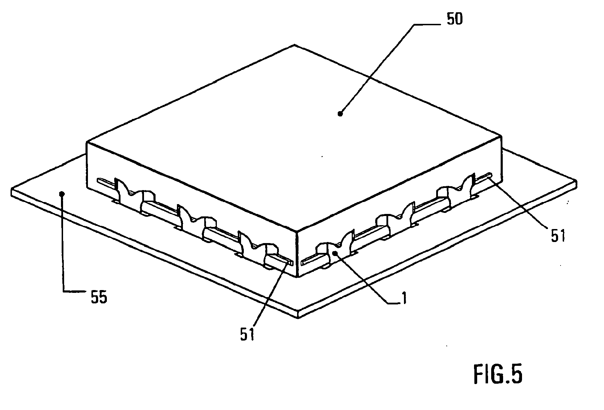

The hold down device will be described in more detail in connection with Figures 1-4. The hold down device 1 comprises a base plate 10, which is fixed or connected to a circuit board as explained in more detail in connection with Figure 5. The base plate is a substantially planar plate having a rectangular form. From the base plate there are extending two contact portions 20 and 30. The two contact portions extend substantially perpendicular to the base plate 10. Each contact portion comprises two free ends 21, 22 and 31, 32, respectively. Each contact portion further comprises a connecting section 25 and 35. The connecting section of each contact portion connects the free ends to each other and connects the free ends to the base plate 10. The connecting sections 25 and 35 extend from two opposite edges of the base plate. In the embodiment shown, the connecting sections extend over a portion of the edges of the base plate 10.

Preferably, the hold down device is a one-piece unit cut out from a metal sheet.

As can be seen particularly in Figure 4, the two contact portions 20 and 30 have a U-shaped form. The free ends 31 and 32 of the contact portion 30 are bent in the direction of the other contact portion 20 towards the middle axis A shown in Figure 4. Additionally, the free ends 21 and 22 of the contact portion 20 are bent towards the other contact portion 30. As can be seen in Figure 4, the free ends are bent in such a way that the free ends of one contact portion are situated offset to the free ends of the other contact portion. In the embodiment shown in Figure 3 and 4, the free ends of each contact portion terminate in a plane going through the axis A. In the embodiment shown, end surfaces 33 and 34 of the free ends 31 and 32 and end surfaces 23 and 24 end in the same plane, a plane perpendicular to the base plate 10 going through the axis A. The cover for shielding the electronic component (not shown) will be inserted into the hold down device from above along this plane. By inserting the side surfaces of a cover 50 shown in Figure 5, the free ends of the contact portions will be pushed away from each other. In the embodiments shown in Figure 3 and 4, the contact distance between the end surfaces of one contact portion to the end surfaces of the other contact portions is zero. When a cover is inserted having a predetermined width (e.g. 0.3-0.5 mm) the resilient free ends will be urged away from each other by said distance. The contact force with which the end surfaces are contacting the side surfaces of the cover 50 depend on the preset curvature of the free ends.

With the embodiment shown in the figures, a high contact force can be obtained, as the distance of the contact surfaces as seen from the insertion direction is approximately zero.

It is possible to apply another contact force by adapting the curvature of the free ends 21, 22 and 31 and 32.

As can be seen in Figure 3, the distance between the two contact surfaces 33 and 23 is zero, as these contact surfaces lie within the same plane. However, it is also possible to provide a certain gap between the two contact surfaces. The wider the gap between the two contact or end surfaces, the smaller the normal contact force with which the free ends contact the side surfaces of a cover.

For certain applications it might be necessary to further increase the contact forces. This is possible by increasing the curvature of the free ends in such a way that the free ends of one contact portion are arranged overlapping the free ends of the other contact portion. In the example shown in Figure 4 this would mean that, by way of example, the end surface 24 would not terminate at axis A, but would further protrude in the direction of the other contact portion 30. Additionally, the end surface 34 would be further bent so as to further extend into the direction of the contact portion 20.

As can be seen in Figures 1 and 2, the connecting section has a V-formed shape, a recess 26 being formed in the middle between the two free ends 21 and 22. The two free ends 21 and 22 have a lower edge 27 and 28, which is positioned at a predetermined distance h to the base plate 10. The fixing of the cover 50 by way of the lower edge of the free ends will be explained in connection with Figure 5 lateron. As can be seen in connection with Figure 3, the hold down device has a large area for contacting the cover. This contact surface provided by the end surfaces 23 and 33 ensure the mechanical and the electrical connection of the cover to the hold down device. The upper end of the free end of each contact portion is shown in a tapered form. This tapered end 29 and 39 helps to guide the insertion of the side surfaces of the cover 50.

In Figure 5 the hold down device 1 is shown fixed to a circuit board 55. The cover is fixed to the circuit board by three hold down devices arranged at each side of the shielding cover 50. The hold down devices 1 shown in Figure 5 can be fixed on the circuit board by way of soldering, so that the hold down device electrically contacts the circuit board and electrically contacts the shielding. However, the hold down device can also be fixed on the circuit board 55 using other fixing techniques. It should be understood that both the shielding and the hold down device are fabricated from a conducting material. The number of the hold down devices and the distances between two different hold down devices for fixing a cover depends on the required shielding properties. Depending on the electromagnetic compatibility requirements, the distance between the hold down devices will be determined. As can be seen in Figure 5, the cover has a box-shaped form. On each of the side surfaces the cover comprises a projection rib 51. This projection rib helps to securely connect the cover 50 to the hold down devices. When the cover is inserted between the two contact portions and arrives at the final position, the free ends of the contact portions engage the space over the projection rib so as to fixedly arrange the cover on the circuit board. When the cover is inserted between the two contact portions of the hold down device, the free ends will cross the projection rib 51, and the projection rib will be accommodated in the space between the base plate and the lower edge 27 and 28 of the free ends. It should be understood that the height h will be selected in such a way that the projection rib 51 of the cover 50 can be accommodated in the space having the height h. From the way of fixing the cover to the hold down device it also follows that the lower edge 27 and 28 of the free ends 27 and 28 does not have a tapered form as the upper end 29.

To those skilled in the art it will become clear that the above described design of the hold down device provides a hold down device which reliably contacts and holds a shielding cover on a circuit board. The arrangement of the two resilient free ends allows a large spring travel and therefore allows an adjustment of the contact forces in accordance with different needs. The contact forces can also be adapted by adapting the curvature of the free ends in such a way that the free ends are overlapping each other or are positioned within one plane. A large spring travel allows a better locking of the cover on the circuit board due to higher contact forces.

## Claims

1. Hold down device for fixing a cover (50) on a circuit board (55), comprising:
- a base plate (10)
- two contact portions (20, 30) extending substantially perpendicular to the base plate, the two contact portions receiving the cover in between,
**characterized in that**
- each contact portion comprises two free ends (21, 22, 31, 32), the free ends of each contact portion being bent in direction of the other contact portion,
- the contact portions (20, 30) are facing each other, each contact portion having a U-shaped form,
- end surfaces (23, 24, 33, 34) of the free ends are contacting the cover (50) when it is inserted between the two contact portions.

2. Hold down device according to claim 1, **characterized in that** each contact portion (20, 30) further comprises a connecting section (25, 35) connecting the two free ends and connecting the free ends to the base plate (10).

3. Hold down device according to claim 1 or 2, **characterized in that**, when the cover (50) is not inserted between the two contact portions (20, 30), the end surfaces (23, 24, 33, 34) of the free ends of the two contact portions are positioned substantially within a plane which is substantially perpendicular to the base plate (10).

4. Hold down device according to claim 1 or 2, **characterized in that** the free ends (21, 22) of one contact portion (20) are arranged overlapping the free ends (31, 32) of the other contact portion (30).

5. Hold down device according to any of the preceding claims, **characterized in that** the edge (27, 28) of the free ends facing the base plate of the two contact portions is arranged at a predetermined distance (h) to the base plate (10).

6. Hold down device according to any of claims 2 to 5, **characterized in that** the connecting section (25, 35) connecting the two free ends has a V-shaped form.

7. Hold down device according to any of the preceding claims, **characterized in that** the base plate (10) of the holding device is fixed on the circuit board (55).

8. Hold down device according to any of the preceding claims, **characterized in that** the cover is an electromagnetic shielding.

9. System comprising:
- a circuit board (55),
- a cover (50) to be positioned on the circuit board,
- a hold down device connected to the circuit board, as mentioned in the preceding claims, which is fixing the cover on the circuit board, wherein the cover comprises at least one projection rib (51) on a surface of the cover, the lower edge (27, 28) of the free ends of the contact portions engaging the projection rib (51).

## Patentansprüche

1. Niederhaltevorrichtung zum Befestigen einer Abdeckung (50) auf einer Leiterplatte (55), umfassend:
- eine Basisplatte (10),
- zwei Kontaktelemente (20, 30), die sich im Wesentlichen senkrecht zu der Basisplatte erstrecken, wobei die Kontaktelemente die Abdeckung dazwischen aufnehmen,
**dadurch gekennzeichnet, dass**
- jedes Kontaktelement zwei freie Enden (21, 22, 31, 32) umfasst, wobei die freien Enden jedes Kontaktelements in Richtung des anderen Kontaktelements gebogen sind,
- die Kontaktelemente (20, 30) einander gegenüberliegen, wobei jedes Kontaktelement eine U-förmige Form hat,
- Endoberflächen (23, 24, 33, 34) der freien Enden mit der Abdeckung (50) in Berührung sind, wenn diese zwischen den zwei Kontaktelementen eingesetzt ist.

2. Niederhaltevorrichtung gemäß Anspruch 1, **dadurch gekennzeichnet, dass** jedes Kontaktelement (20, 30) außerdem einen Verbindungsabschnitt (25, 35) umfasst, der die zwei freien Enden verbindet und die freien Enden mit der Basisplatte (10) verbindet.

3. Niederhaltevorrichtung gemäß Anspruch 1 oder 2, **dadurch gekennzeichnet, dass**, die Endoberflächen (23, 24, 33, 34) der freien Enden der zwei Kontaktelemente, wenn die Abdeckung (50) nicht zwischen den zwei Kontaktelementen (20, 30) eingesetzt ist, im Wesentlichen in einer Ebene positioniert sind, welche im Wesentlichen senkrecht zu der Basisplatte (10) ist.

4. Niederhaltevorrichtung gemäß Anspruch 1 oder 2, **dadurch gekennzeichnet, dass** die freien Enden (21, 22) eines Kontaktelements (20) so angeordnet sind, dass sie die freien Enden (31, 32) des anderen Kontaktelements (30) überlappen.

5. Niederhaltevorrichtung gemäß einem der vorangegangenen Ansprüche, **dadurch gekennzeichnet, dass** der Rand (27, 28) der freien Enden, der der Basisplatte der zwei Kontaktelemente zugewandt ist, in einem bestimmten Abstand (h) zu der Basisplatte (10) angeordnet ist.

6. Niederhaltevorrichtung gemäß einem der Ansprüche 2-5, **dadurch gekennzeichnet, dass** der Verbindungsabschnitt (25, 35), der die zwei freien Enden verbindet, eine V-förmige Form hat.

7. Niederhaltevorrichtung gemäß einem der vorangehenden Ansprüche, **dadurch gekennzeichnet, dass** die Basisplatte (10) der Haltevorrichtung an der Leiterplatte (55) befestigt ist.

8. Niederhaltevorrichtung gemäß einem der vorangehenden Ansprüche, **dadurch gekennzeichnet, dass** die Abdeckung eine elektromagnetische Abschirmung ist.

9. System, umfassend:
- eine Leiterplatte (55),
- eine Abdeckung (50), die auf der Leiterplatte positioniert werden soll,
- eine Niederhaltevorrichtung, die mit der Leiterplatte verbunden ist, wie sie in den vorangehenden Ansprüchen beschrieben ist, welche die Abdeckung auf der Leiterplatte fixiert, wobei die Abdeckung wenigstens eine vorstehende Rippe (51) an einer Oberfläche der Abdeckung hat, wobei der untere Rand (27, 28) der freien Enden der Kontaktelemente mit der vorstehenden Rippe (51) im Eingriff ist.

## Revendications

1. Dispositif de retenue pour fixer un couvercle (50) sur une carte imprimée (55), comprenant:
- une plaquette de base (10)
- deux parties de contact (20, 30) s'étendant essentiellement perpendiculairement à la plaquette de base, les deux parties de contact recevant le couvercle entre elles,
**caractérisé en ce que**
- chaque partie de contact comporte deux extrémités libres (21, 22, 31, 32), les extrémités libres de chaque partie de contact étant pliées en direction de l'autre partie de contact,
- les parties de contact (20, 30) sont en vis-à-vis, chaque partie de contact ayant une forme en U,
- des surfaces d'extrémité (23, 24, 33, 34) des extrémités libres sont en contact avec le couvercle (50) lorsqu'il est inséré entre les deux parties de contact.

2. Dispositif de retenue selon la revendication 1, **caractérisé en ce que** chaque partie de contact (20, 30) comporte en outre une section de liaison (25, 35) reliant les deux extrémités libres et reliant les extrémités libres à la plaquette de base (10).

3. Dispositif de retenue selon la revendication 1 ou 2, **caractérisé en ce que**, lorsque le couvercle (50) n'est pas inséré entre les deux parties de contact (20, 30), les surfaces d'extrémité (23, 24, 33, 34) des extrémités libres des deux parties de contact sont positionnées essentiellement dans un plan qui est essentiellement perpendiculaire à la plaquette de base (10).

4. Dispositif de retenue selon la revendication 1 ou 2, **caractérisé en ce que** les extrémités libres (21, 22) d'une partie de contact (20) sont disposées chevauchant les extrémités libres (31, 32) de l'autre partie de contact (30).

5. Dispositif de retenue selon l'une quelconque des revendications précédentes, **caractérisé en ce que** l'arête (27, 28) des extrémités libres en vis-à-vis de la plaquette de base des deux parties de contact est disposée à une distance prédéterminée (h) de la plaquette de base (10).

6. Dispositif de retenue selon l'une quelconque des revendications 2 à 5**, caractérisé en ce que** la section de liaison (25, 35) reliant les deux extrémités libres a une forme en V.

7. Dispositif de retenue selon l'une quelconque des revendications précédentes, **caractérisé en ce que** la plaquette de base (10) du dispositif de retenue est fixée sur la carte imprimée (55).

8. Dispositif de retenue selon l'une quelconque des revendications précédentes, **caractérisé en ce que** le couvercle est un écran électromagnétique.

9. Système comprenant
- une carte imprimée (55),
- un couvercle (50) à positionner sur la carte imprimée,
- un dispositif de retenue, relié à la carte imprimée tel que mentionné dans les revendications précédentes, fixant le couvercle sur la carte imprimée, dans lequel le couvercle comprend au moins une nervure saillante (51) sur une surface du couvercle, l'arête inférieure (27, 28) des extrémités libres des parties de contact étant en prise avec la nervure saillante (51).
